# EUROPÄISCHE PATENTANMELDUNG

(11) **EP 4 531 503 A1**
(43) Veröffentlichungstag der Anmeldung: **02.04.2025**
(21) Anmeldenummer: 24202130.1
(22) Anmeldetag: 24.09.2024
(51) Int. Cl.: H05K 3/10, H05K 1/02, H05K 1/03, H05K 3/28, H05K 3/32

(54) **VERFAHREN ZUM HERSTELLEN EINES VERDRAHTUNGS-BAUTEILS SOWIE VERDRAHTUNGS-BAUTEIL**

(30) Priorität: 27.09.2023 DE 102023126329
(71) Anmelder: Diehl Advanced Mobility GmbH, 16792 Zehdenick (DE)
(72) Erfinder: Kattau, Wolfgang, 17268 Templin (DE); Weyh, Jürgen, 98587 Steinbach-Hallenberg (DE); Wieberger, Martin, 12203 Berlin (DE); Husen, Jakob Anton, 10439 Berlin (DE); Kremser, Dario, 16567 Schönfließ (DE); Kempe, Lennard, 14612 Falkensee (DE)
(74) Vertreter: Diehl Patentabteilung

(57) **Zusammenfassung**

Die vorliegende Erfindung betrifft ein Verfahren zum Herstellen eines Verdrahtungs-Bauteils (10) mit mindestens einem Leiterpfad (z. B. 11) insbesondere für oder als Bestandteil eines Zellkontaktiersystems (104), mit folgenden Schritten:
Bereitstellen eines ein- oder mehrschichtigen Trägers (15),
Bereitstellen eines elektrischen Leiters (12) für den Leiterpfad (11),
Ausgeben des elektrischen Leiters (12) aus einem Führungskopf (13), wobei der Träger (15) und/oder der Führungskopf (13) in einer vorgebbaren Bahn zueinander zumindest in x- und y-Richtung, vorzugsweise in x-, y- und z-Richtung, translatorisch maschinell bewegt werden und der elektrische Leiter (12) zur Festlegung des Leiterpfades (11) entsprechend am Träger (15) fixiert wird, wobei der elektrische Leiter (12) am Träger (15) mittels bereichsweiser, thermoplastischer Aufweichung des Trägers (15) fixiert wird.

Zudem betrifft die Erfindung ein entsprechendes Verdrahtungs-Bauteil (10).

## Beschreibung

Die Erfindung betrifft ein Verfahren zum Herstellen eines Verdrahtungs-Bauteils mit mindestens einem Leiterpfad, insbesondere für den Einsatz in einem oder als Bestandteil eines Zellkontaktiersystems gemäß dem Oberbegriff des Anspruchs 1 sowie ein entsprechendes Verdrahtungs-Bauteil gemäß Anspruch 22.

### Ausgangssituation der Erfindung

Zellkontaktiersysteme finden Anwendung bei modernen Energiespeichermodulen, z.B. für Elektrofahrzeuge. Ein Zellkontaktiersystem umfasst Busbars (Zellverbinder) und Elektronikkomponenten, welche von einem Trägerrahmen gehalten werden. Ferner gibt es trägerrahmenlose Zellkontaktiersysteme, bei welchen die Busbars (Zellverbinder) und Elektronikkomponenten z. B. von einer Folie gehalten werden. Busbars verfügen über ein Kompensationselement zur Reduzierung der Krafteinwirkung auf die Zellterminals. Spannungsabgriffe dienen zur Überwachung der Energiespeicherzellen und ermöglichen aktives/passives Zellbalancing. Eine Temperaturüberwachung kann im Zellkontaktiersystem integriert oder außerhalb vorgesehen sein. In Zellkontaktiersystemen sind elektrische Leitungen in Form von Leiterpfaden integriert. Hierbei handelt es sich nicht um leistungsführende Busbars, sondern um Leitungen zur Verschaltung der Elektronikkomponenten. In aktuellen Produkten von Zellkontaktiersystemen sind als Leiterpfade bzw. elektrische Leitungen Kabelbäume, FPC bzw. Flexleiter, und PCBs gebräuchlich. Montage und Handhabung der entsprechenden Leitungen können dabei aufwendig bzw. schwierig sein. Dies gilt insbesondere für flexible Leiterplatten und Kabelbäume, da diese biegeschlaffe Bauteile sind, welche in der Handhabungstechnik schwierig verarbeitet werden können.

### Druckschriftlicher Stand der Technik

Aus der DE 10 2019 000 856 A1 ist ein Verfahren zur Herstellung eines Leiterpfades eines Zellkontaktiersystems bekannt. Hierbei wird ein elektrischer Leiter mittels eines Führungskopfs mit einer Ausgabeöffnung maschinell in einer vorgebbaren Bahn relativ zu einem Grundkörper geführt und auf dem Grundkörper verlegt, um den Leiterpfad zu bilden. Der elektrische Leiter wird hierbei an einem Startknoten befestigt und mittels zylinderartiger, an der Oberfläche des Grundkörpers emporragender Führungselemente verlegt. Die Führungselemente dienen dazu, den elektrischen Leiter unter mechanischer Spannung zu halten. Dieses Verfahren ist in mehrerlei Hinsicht nachteilig. Zum einen bedingt der Einsatz der Führungselemente zwangsläufig eine notwendige Bauhöhe in z-Richtung. Zum anderen müssen die Führungselemente vorab an dem Grundkörper befestigt werden. Das Verfahren ist somit zum einen aufwendig, zum anderen aber auch bei Anforderungen eines besonders niedrigen Bauraums in z-Höhe nicht einsetzbar.

### Aufgabe der vorliegenden Erfindung

Die Aufgabe der vorliegenden Erfindung besteht darin, ein gattungsgemäßes Verfahren zur Verfügung zu stellen, welches die vorgenannten Nachteile vermeidet. Zudem besteht die Aufgabe der vorliegenden Erfindung darin, ein entsprechendes Verdrahtungsbauteil zur Verfügung zu stellen, welches die vorgenannten Nachteile vermeidet.

### Lösung der Aufgabe

Die vorliegende Aufgabe wird durch ein Verfahren gemäß den Merkmalen des Anspruchs 1 gelöst. Ferner wird die Aufgabe durch ein Verdrahtungs-Bauteil gemäß den Merkmalen des Anspruchs 22 gelöst. Zweckmäßige Ausgestaltungen des erfindungsgemäßen Verfahrens werden in abhängigen Ansprüchen beansprucht.

Dadurch, dass der elektrische Leiter am Träger mittels thermoplastischer bereichsweiser Aufweichung des Trägers fixiert wird, wird zum einen ein Leiterpfad geschaffen, welcher eine erhebliche Bauraumminimierung in z-Richtung ermöglicht, da an der Oberfläche emporragende Führungselemente vollständig entfallen. "Bereichsweise thermoplastische Aufweichung" des Trägers bedeutet eine durch thermoplastische Erwärmung stattfindende Aufweichung eines Bereichs eines einschichtigen Trägers oder eine Aufweichung mindestens eines Bereichs eines mehrschichtigen Trägers. Auch entfällt eine notwendige Fixierung des elektrischen Leiters an einem emporragenden Klemm- oder Haltemittel zu Beginn sowie auch am Ende eines Leiterpfades. Schließlich ist auch die produktionstechnische Vorbereitung des Trägers aufgrund des Wegfalls der Führungselemente wesentlich einfacher. Das erfindungsgemäße Verfahren ermöglicht zudem eine wirksame Einsparung an Material des elektrischen Leiters (z.B. Kupfer), da ein mehrfaches Umwickeln von Führungselementen ersatzlos wegfällt. Im Vergleich zu einem PCB (Printed Circuit Board) und einem FPC (Flexible Printed Circuit) ist in vorteilhafterweise kein Belichten und nasschemisches Ätzen erforderlich. Darüber hinaus ist auch die Einsparung an Material des elektrischen Leiters (z.B. Kupfer) gegenüber einem PCB und FPC beträchtlich. Das erfindungsgemäße Verfahren ist zudem dahingehend vorteilhaft, dass es sowohl an einem flächenflexiblen Träger als auch an einem starren Träger gleichermaßen einsetzbar ist. Das Verfahren ermöglicht es zudem, den elektrischen Leiter in einer individuellen Orientierung in x- sowie y-, vorzugsweise in x-, y- sowie z-Richtung, also entlang eines individuell geformten Formkörpers, zu verlegen.

Gemäß der Erfindung kann der Träger eine Einbettungsschicht zur Fixierung des elektrischen Leiters umfassen. In der Einbettungsschicht kann der elektrische Leiter vorzugsweise über einen Teilbereich seines äußeren Umfangs von der Einbettungsschicht kontaktiert sein, wodurch die Fixierung des elektrischen Leiters am Träger begründet wird. Die Einbettungsschicht kann den elektrischen Leiter auch vollständig umhüllen.

Gemäß der Erfindung kann der Träger ein flexibler Körper, insbesondere eine Folie sein. Daraus resultiert der Vorteil, dass der mit dem Leiterpfad versehene Träger z. B. auf ein Formteil aufgebracht werden kann. Insbesondere kann die Folie auf ein Zellkontaktiersystem formkompatibel aufgebracht werden. Zudem erlaubt diese Ausgestaltung es auch, den mit dem Leiterpfad versehenen Träger als vorzukonfektionierendes Bauteil vorzuhalten und je nach Bedarf mit einem entsprechenden Formkörper eines Zellkontaktiersystems zu verbinden.

Alternativ kann der Träger auch ein starrer Körper, insbesondere ein Formkörper, wie z.B. ein Spritzgießteil, sein. Hierdurch kann der Träger selbst bei Bedarf eine gewisse Tragfunktion übernehmen. Beispielsweise kann der Träger die Tragfunktion eines Zellkontaktiersystems gewährleisten oder zumindest dazu beitragen.

Gemäß der vorliegenden Erfindung kann sich die Einbettungsschicht auf dem flexiblen oder starren Körper befinden. Vorzugsweise handelt es sich bei der Einbettungsschicht um eine Klebeschicht, die auf dem flexiblen oder starren Körper aufgebracht ist. Die Klebeschicht dient einerseits zur Fixierung des elektrischen Leiters, indem sie den elektrischen Leiter einbettet. Zum anderen kann sie bei Bedarf auch dazu dienen, eine an der Oberseite aufgebrachte weitere Schicht (z.B. Laminatschicht oder Schutzschicht) zu fixieren oder aber zur Fixierung anderer Elemente dienen.

Gemäß der vorliegenden Erfindung kann die Einbettungsschicht durch einen von außen einwirkenden Energieeintrag in die Einbettungsschicht aufgeweicht werden, um den elektrischen Leiter zu fixieren, insbesondere darin einzubetten.

Bei dem von außen einwirkenden Energieeintrag in die Einbettungsschicht kann es sich um das Einbringen von thermischer Erwärmung oder um die Anwendung hochfrequenter Vibration handeln.

Vorzugsweise kann der von außen einwirkende Energieeintrag in die Einbettungsschicht durch eine hochfrequente Vibration des den elektrischen Leiter führenden Führungskopfs während der Verlegung des elektrischen Leiters erfolgen. Hierbei führt die hochfrequente Vibration des Führungskopfs zu einer Aufweichung der Einbettungsschicht, wodurch der elektrische Leiter in der Einbettungsschicht verlegt und darin fixiert werden kann. Die Vibration des Führungskopfs erfolgt hierbei vorzugsweise im Ultraschallbereich.

Gemäß einer alternativen Ausgestaltung der vorliegenden Erfindung kann der elektrische Leiter durch die Anwendung einer mechanischen Kraft in eine zumindest teilweise bereits aufgeweichte oder viskose Einbettungsschicht eingefügt werden. Insbesondere kann die mechanische Kraft durch den Führungskopf des elektrischen Leiters auf Letzteren aufgebracht werden.

Gemäß dem erfindungsgemäßen Verfahren kann der am Träger verlegte elektrische Leiter bei Bedarf so verlegt werden, dass er Unterbrechungen aufweist. Darüber hinaus kann der elektrische Leiter so verlegt werden, dass sich der verlegte elektrische Leiter überkreuzt. Zur Vermeidung eines Kurzschlusses ist hierzu ein mit einer Isolierung oder einer Lackierung bereits versehener elektrischer Leiter zu verwenden. Des Weiteren kann der am Träger verlegte elektrische Leiter in beliebiger Richtung in x- und y-Richtung sowie bei Bedarf sogar auch in z-Richtung verlaufen.

Gemäß der vorliegenden Erfindung kann der am Träger verlegte elektrische Leiter bei Bedarf aus dem Träger herausgeführt werden, um beispielsweise einen Kontakt zu einem anderen Element außerhalb des Trägers herzustellen oder eine funktionsbedingte Lücke innerhalb des Trägers zu überspringen.

Gemäß einer zweckmäßigen Ausgestaltung kann der elektrische Leiter mit Unterbrechungen verlegt werden. Entsprechende Unterbrechungen können somit sogleich während des Einbettungsprozesses vorgenommen werden, sodass nachträgliche Auftrennungen, wie bei dem Verfahren der DE 10 2019 000 856 A1, entfallen.

Gemäß der vorliegenden Erfindung kann der elektrische Leiter ohne Unterbrechungen verlegt werden, wobei anschließend durch Auftrennung des verlegten elektrischen Leiters mehrere getrennte Leiterpfade gebildet werden.

Gemäß der vorliegenden Erfindung kann am Träger mindestens ein funktionales Element angeordnet sein. Hierbei kann es sich vorzugsweise um mindestens ein Sensorelement, mindestens eine Steckeinrichtung, mindestens eine PCB, FPC oder dergleichen handeln.

Gemäß der vorliegenden Erfindung kann der elektrische Leiter isoliert (z.B. lackiert) oder nicht isoliert sein.

Gemäß der vorliegenden Erfindung kann auf die Oberseite des mindestens einen Leiterpfads mindestens eine Abdeckschicht, vorzugsweise eine Abdeckfolie, aufgebracht werden. Beispielsweise kann der Träger an seiner Oberseite eine Laminatschicht umfassen. Auch kann der Träger als Schicht oder Schichtenfolge ein Teil eines laminierten Zellkontaktiersystems sein. Aufgrund der durch die Erfindung bedingten Möglichkeit des Aufbringens einer Abdeckschicht auf den Träger kann der Träger somit auch in einfacher Weise in ein laminiertes Zellkontaktiersystem integriert werden.

Auf der Abdeckschicht können weitere funktionale Elemente, insbesondere mindestens ein Sensorelement, mindestens ein Steckelement und/oder mindestens eine PCB oder FPC angeordnet sein.

Gemäß der Erfindung kann der Träger mit den einzelnen Zellverbindern (Busbars) zu einem vorkonfektionierten Montageteil verbunden werden. Ein entsprechend vorkonfektioniertes Montageteil kann insbesondere als Zellkontaktiersystem für eine automatisierte Montage verwendet werden.

Nach einer weiteren Ausgestaltung kann der Träger Laschen umfassen. Diese können dazu dienen, eine Fixierung der Zellverbinder am Träger zu ermöglichen. Hierbei kann sich der Leiterpfad auch in den Bereich der Laschen erstrecken. Dies kann dann sinnvoll sein, wenn sich z. B. im Bereich der Zellverbinder ein Sensor befindet. Die Laschen können vorzugsweise auch für einen Höhenversatz des Trägers sorgen, indem sie z. B. einen stufenartig geformten Abschnitt aufweisen. Hierdurch liegt der Träger etwas höher als die Befestigungsebene der Laschen bezogen auf die Oberfläche der Terminals. Dadurch entsteht ein Raum unterhalb des Trägers, der für weitere Funktionselemente genutzt werden kann.

Der elektrische Leiter kann lediglich über einen Teilbereich seines äußeren Umfangs oder über seinen gesamten äußeren Umfang von dem Träger oder der Einbettungsschicht kontaktiert bzw. umgeben sein.

Die vorliegende Erfindung betrifft darüber hinaus ein Verdrahtungs-Bauteil mit mindestens einem Leiterpfad, insbesondere für oder als Bestandteil eines Zellkontaktiersystems, welches gemäß dem Verfahren nach mindestens einem der Ansprüche 1-21 hergestellt worden ist.

### Beschreibung der Erfindung anhand von Ausführungsbeispielen

Zweckmäßige Ausgestaltungen der vorliegenden Erfindung werden anhand von Zeichnungsfiguren nachstehend näher erläutert. Identische Merkmale sind der Übersichtlichkeit halber lediglich einmalig mit Bezugszeichen versehen. Es zeigen:
- Fig. 1: eine perspektivische Darstellung eines Energiespeichermoduls mit einem Beispiel eines Verdrahtungs-Bauteil, welches gemäß dem erfindungsgemäßen Verfahren hergestellt worden ist;
- Fig. 2: eine stark vereinfachte schematische Darstellung des Verlegeprozesses des elektrischen Leiters auf einem Träger gemäß einem Ausführungsbeispiel der vorliegenden Erfindung;
- Fig. 3: eine perspektivische Darstellung eines dreidimensional geformten Trägers mit einem durchgängig verlegten elektrischen Leiter;
- Fig. 4: den Träger gemäß Fig. 3 nach einem Zuschnitt zur Auftrennung des elektrischen Leiters in Einzel-Leiterpfade;
- Fig. 5: eine vergrößerte Darstellung des mit A gekennzeichneten Bereichs von Fig. 4;
- Fig. 6: den Träger gemäß Fig. 4, welcher durch Fixierung mit den einzelnen Zellverbindern zu einem vorkonfektionierten Montageteil eines Zellkontaktiersystems verbunden ist; sowie
- Fig. 7: eine schematische Detailschnittdarstellung einer ersten Ausgestaltung, bei der der elektrische Leiter ohne oberseitige Abdeckung unmittelbar in eine Einbettungsschicht des Trägers eingebunden ist (Fig. 7a); bei der der elektrische Leiter gemäß Fig. 7a mit einer oberseitigen Abdeckschicht überzogen ist (Fig. 7b); bei der der elektrische Leiter in eine auf eine Folie aufgebrachte Einbettungsschicht des Trägers eingebettet ist, ohne oberseitiger Abdeckung (Fig. 7c) sowie bei der der elektrische Leiter aus Fig. 7c oberseitig mit einer Abdeckschicht abgedeckt ist (Fig. 7d).

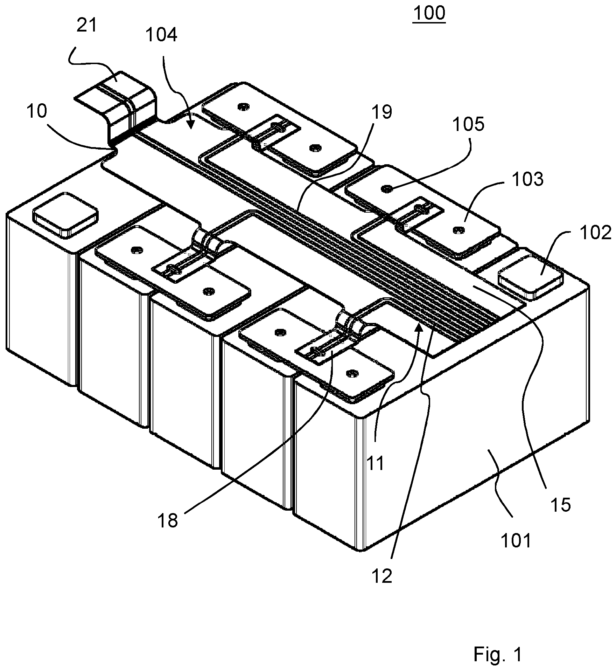

Bezugsziffer 100 in Fig. 1 zeigt ein Energiespeichermodul, beispielsweise ein Energiespeichermodul in Form eines Lithium-Ionen-Akkus, welcher z. B. bei Elektrofahrzeugen eingesetzt wird. Das Energiespeichermodul 100 umfasst eine Mehrzahl von nebeneinander angeordneten Energiespeicherzellen 101 mit jeweils oberseitig angeordneten Terminals 102, die über sogenannte Zellverbinder 103 (auch Busbars genannt) elektrisch miteinander verbunden sind.

An der Oberseite des Energiespeichermoduls 100 befindet sich ein Verdrahtungs-Bauteil 10, welches zusammen mit den Zellverbindern 103 ein Montageteil bzw. ein Zellkontaktiersystem bildet. An der Oberseite des Verdrahtungs-Bauteils 10 befinden sich ein Leiterpfad 11 in Form einer Mehrzahl von Einzel-Leiterpfaden 19, die durch elektrische Leiter 12 gebildet werden. Der Begriff Leiterpfad ist hierbei in Abgrenzung zu leistungsführenden Leitern zu verstehen und dient der Diagnose, Steuerung und Regelung von Zellen sowie der Temperatur-, Spannungs-, Stromerfassung an einer Energiespeicherzelle 101 bzw. an dem Energiespeichermodul 100.

Der Leiterpfad 11 des Verdrahtungs-Bauteils 10 kann hierbei auch ein Abschnitt bzw. Teilstück eines eigentlich größeren Leiterpfades bzw. Gesamtpfades sein, der stückweise aus Einzel-Leiterpfaden 19 kombiniert wird. Das Verdrahtungs-Bauteil 10 ist insbesondere auch ein Träger für Sensoren und/oder Deckmittel und/oder Elektronikbauteile (welche jeweils in Fig. 1 nicht dargestellt sind). Das Verdrahtungs-Bauteil 10 von Fig. 1 besitzt jeweils seitlich angeordnete Laschen 18, die dazu vorgesehen sind, die Zellverbinder 103 zu tragen. Der Leiterpfad 11 erstreckt sich auch in den Bereich der Laschen 18 hinein. Die Laschen 18 sorgen auch für einen Höhenversatz des Trägers 15, indem sie einen im Wesentlichen stufenartig geformten Abschnitt aufweisen. Hierdurch liegt der Träger 15 etwas höher als die Befestigungsebene der Laschen 18 bezogen auf die Oberfläche der Terminals 102. Dadurch entsteht ein Raum unterhalb des Trägers, der für weitere (nicht dargestellte) Funktionselemente genutzt werden kann.

Des Weiteren verfügt das Verdrahtungs-Bauteil 10 über einen stirnseitig angeordneten, stufenartig nach oben verlaufenden Anschluss 21 zum Anschluss an eine in Fig. 1 nicht gezeigte Anschlusseinrichtung, z.B. an eine PCB oder an eine FPC.

Auch kann der elektrische Leiter 12 des Verdrahtungs-Bauteils 10 mit einem ebenfalls in Fig. 1 nicht gezeigten, aktiven oder passiven Bauelement direkt kontaktiert sein.

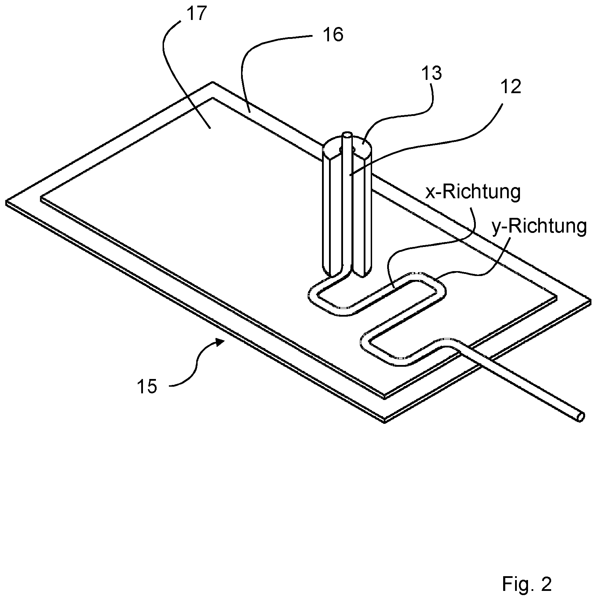

Unter Bezugnahme auf Fig. 2 wird das erfindungsgemäße Verfahren näher beschrieben. Zunächst wird ein flächiger Träger 15 bereitgestellt. Dieser kann gemäß der Ausgestaltung nach Fig. 2 eine Folie 16 umfassen, an deren Oberseite eine Einbettungsschicht 17 aufgebracht ist. Bei der Einbettungsschicht 17 kann es sich z.B. um eine Klebeschicht handeln.

Der elektrische Leiter 12 wird unter Verwendung eines automatisiert geführten Führungskopfes 13 in die Einbettungsschicht 17 eingebettet, wobei der Führungskopf 13 sowie der Träger 15 zueinander in x-Richtung sowie in y-Richtung translatorisch automatisiert bewegbar sind. Darüber hinaus kann der Führungskopf 13 auch rotatorisch bewegbar sein. Gemäß einer weiteren zweckmäßigen Ausgestaltung kann, bei Bedarf, der Führungskopf 13 auch in z-Richtung eine automatisierte Verlegung des elektrischen Leiters 12 vornehmen.

Zum Verlegen des elektrischen Leiters 12 wird von außen ein Energieeintrag in die Einbettungsschicht 17 vorgenommen, sodass die Einbettungsschicht 17 aufweicht, d.h. viskose wird und auf diese Weise der elektrische Leiter 12 in das Material der Einbettungsschicht 17 eingebettet werden kann. Der von außen einwirkende Energieeintrag kann vorzugsweise durch eine hochfrequente Vibration des Führungskopfs 13 während der Verlegung des elektrischen Leiters 12 bewirkt werden. Durch die Vibration des Führungskopfs 13 wird die Einbettungsschicht 17 bzw. die Klebeschicht aufgrund ihres thermoplastischen Verhaltens aufgeweicht. Die Frequenz der Vibration des Führungskopfs 13 kann im Ultraschallbereich liegen. Gemäß einer alternativen Ausgestaltung des erfindungsgemäßen Verfahrens kann das Einbringen einer thermischen Erwärmung auch durch einen thermischen Strahler oder dergleichen erfolgen. Gemäß einer weiteren alternativen Ausgestaltung des erfindungsgemäßen Verfahrens kann der elektrische Leiter 12 auch oder zusätzlich mittels mechanischer Kraft in eine zumindest teilweise bereits aufgeweichte oder viskose Einbettungsschicht 17 eingedrückt werden.

Der am Träger 15 verlegte elektrische Leiter 12 kann bei Bedarf Unterbrechungen aufweisen, sich überkreuzen sowie in x-, y- sowie z-Richtung verlaufen. Der elektrische Leiter 12 kann ohne Isolierung oder aber mit Isolierung verlegt werden.

Der elektrische Leiter 12 kann derart verlegt sein, dass er gemäß Fig. 2 aus dem Träger 15 herausgeführt wird, um beispielsweise eine Verbindung mit einem (nicht dargestellten) externen Bauteil direkt oder indirekt eingehen zu können.

Aufgrund der Verwendung einer Folie 16 mit einer an der Oberseite befindlichen Einbettungsschicht 17 kann das hierdurch geschaffene Verdrahtungs-Bauteil 10 als flexibles Bauteil je nach Bedarf mit einem Formteil verbunden werden. Beispielsweise kann Letzteres mit einem Zellkontaktiersystem verbunden werden. Dies ermöglicht es, dass das Verdrahtungs-Bauteil 10 als flexibles, bei Bedarf mit unterschiedlichsten 3D-Formen zu komplettierendes Bauteil vorgehalten werden kann.

Alternativ zu dem in Fig. 2 gezeigten mehrschichtigen Träger 15 kann auch ein einschichtiger Träger 15 verwendet werden. Hierbei wird in entsprechender Weise eine Aufweichung eines Bereichs des einschichtigen Trägers zur Fixierung des elektrischen Leiters in entsprechender Weise herbeigeführt.

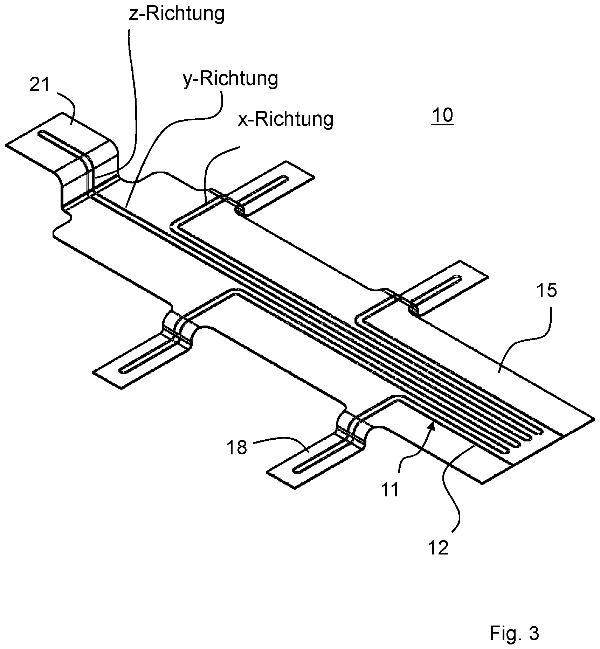

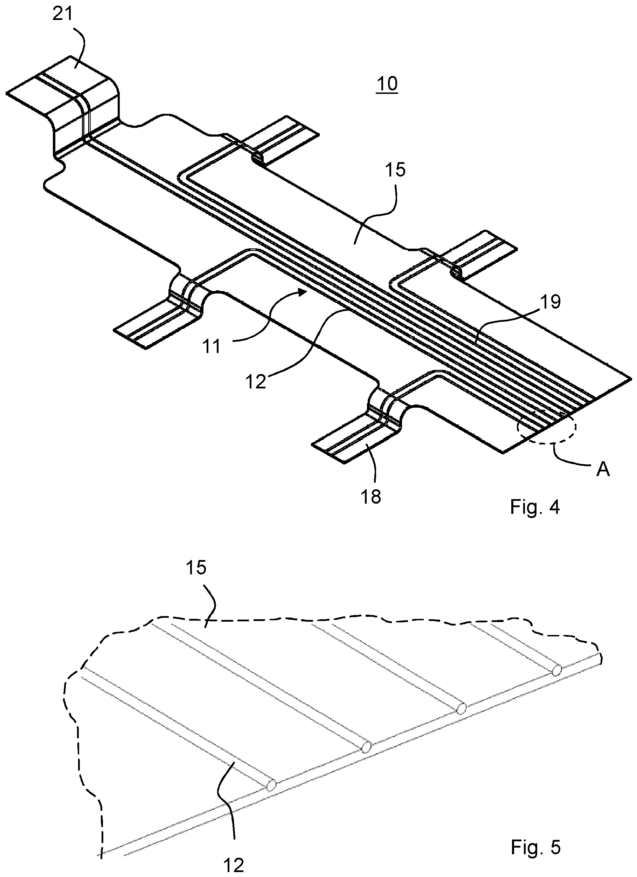

Aus Fig. 3 ist ein bereits mit einem durchgängig verlegten elektrischen Leiter 12 versehener Träger 15 ersichtlich. Der Träger 15 entspricht dem Aufbau des Trägers 15 von Fig. 2, wobei lediglich aus darstellerischen Gründen die oberseitige Einbettungsschicht 17 bzw. Klebeschicht nicht ersichtlich ist. Wie aus Fig. 3 erkennbar, ist der elektrische Leiter 12 entlang des Trägers 15 durchgängig verlegt. Er verläuft auch in Bereiche von seitlich angeordneten Laschen 18 sowie eines stirnseitigen Anschlusses 21. Im Bereich des stufenförmigen Übergangs an den jeweiligen Laschen 18 sowie des Anschlusses 21 verläuft der elektrische Leiter 12 in z-Richtung. Ein entsprechendes, in Fig. 3 dargestelltes Verdrahtungs-Bauteil 10 kann durch Biegen des flächigen Trägers 15 hergestellt werden. Alternativ könnte auch ein entsprechend geformter Träger 15 mit dem elektrischen Leiter auf die beschriebene Art und Weise verbunden werden. Durch einfaches Beschneiden des Trägers 15 im Bereich seiner Laschen 18, seines Anschlusses 21 sowie seines, dem Anschluss 21 gegenüberliegenden Endbereichs können aus dem durchgängig verlegten elektrischen Leiter 12 eine Mehrzahl von Einzel-Leiterpfaden 19 geschaffen werden. Ein entsprechend bearbeiteter Träger 15 bzw. ein entsprechendes Verdrahtungs-Bauteil 10 ist aus Fig. 4 ersichtlich.

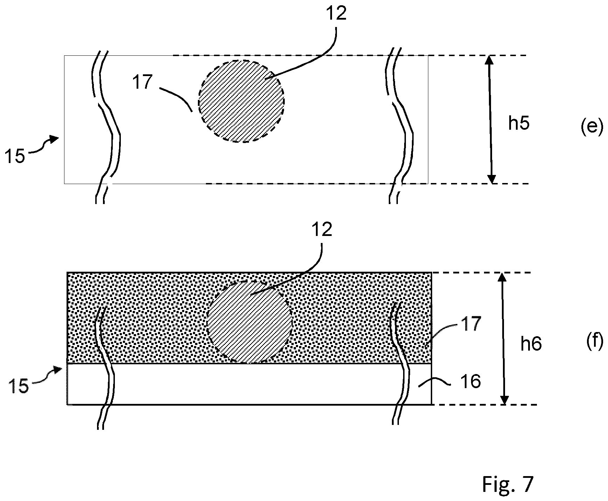

Wie aus Fig. 5 ersichtlich ist, ist der elektrische Leiter 12 in den Oberflächenbereich des Trägers 15 eingebettet, sodass ein Teil des Umfangs des elektrischen Leiters 12 in den Oberflächenbereich des Trägers 15 eintaucht. Alternativ kann der elektrische Leiters 12 auch vollumfänglich in den Oberflächenbereich des Trägers 15 bzw. der Einbettungsschicht 17 eingebettet sein, vgl. Fig. 7(e).

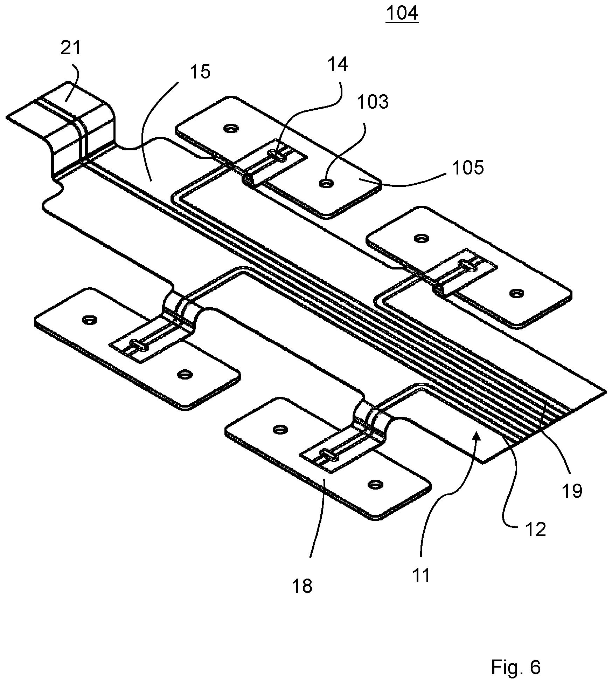

Der Träger 15 der Ausgestaltung nach Fig. 4 kann gemäß Fig. 6 mit Zellverbindern 103 mittels geeigneter Befestigungsmittel 14 zu einer vorkonfektionierten Montageeinheit 104 für das Zellkontaktiersystem komplettiert werden. Eine derartige, vorkonfektionierte Montageeinheit 104 kann in vorteilhafterweise im Herstellungsprozess vorgehalten werden und mittels einer automatisierten Handhabungseinrichtung an der Oberseite der Energiespeicherzellen 101 (vgl. Fig. 1) positioniert und mit den Terminals 102 verbunden werden. Die Verbindung erfolgt beispielsweise durch einen Laserschweißvorgang an den dafür vorgesehenen Schweißpositionen 105 im Bereich der Zellverbinder 103.

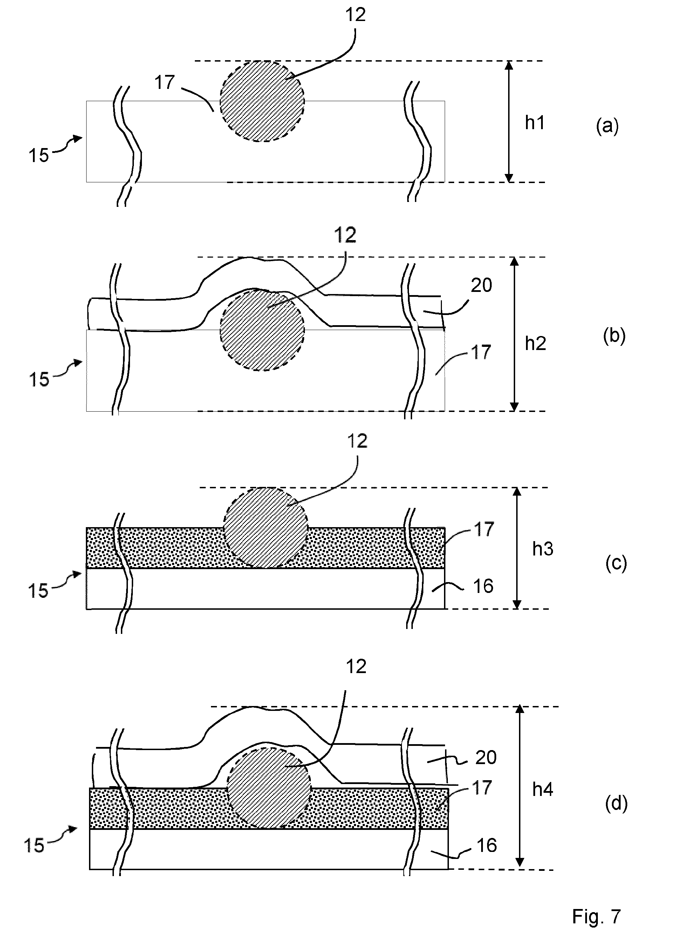

Fig. 7 zeigt stark vereinfachte schematische Schnittdarstellungen eines erfindungsgemäßen Verdrahtungs-Bauteils 10 im Bereich eines verlegten elektrischen Leiters 12 in verschiedenen Alternativen. Fig. 7a zeigt den elektrischen Leiter 12, welcher im Bereich der Einbettungsschicht 17, etwa bis zur Hälfte seines Umfangs in den Träger 15 eintaucht. Die Höhe h1 der Anordnung ist im Vergleich zu dem herkömmlichen, eingangs genannten Verfahren äußerst gering. Bei dem Träger 15 handelt es sich um einen einschichtigen Träger.

Gemäß der Ausgestaltung nach Fig. 7b kann an der Oberseite des Trägers 15 eine Abdeckschicht 20 angeordnet sein. Hierbei kann es sich z. B. um eine Laminierschicht oder um eine Abdeckfolie handeln. Das erfindungsgemäße Verfahren erlaubt es, bei einer vergleichsweise niedrigen Bauhöhe h2 eine effiziente Abdeckung des Leiterpfads 11 bzw. der Einzel-Leiterpfade 19 zu ermöglichen.

Fig. 7c zeigt einen mehrschichtigen Träger 15, insbesondere einen solchen, wie er in Fig. 2 bereits beschrieben worden ist. Auch hier ergibt sich der Vorteil einer sehr niedrigen Bauhöhe h3 bzw. einer ebenfalls niedrigen Bauhöhe h4 bei Einsatz einer entsprechenden Abdeckschicht 20 gemäß Fig. 7d.

Der elektrische Leiter 12 kann alternativ auch über seinen gesamten äußeren Umfang von dem Träger 15 bzw. der Einbettungsschicht 17 kontaktiert bzw. umgeben sein, vgl. Fig. 7 (e) sowie Fig. 7 (f). Auch hierdurch können niedrige Bauhöhen h5 bzw. h6 erzielt

Aufgrund der durch die Erfindung bedingten Möglichkeit des Aufbringens einer Abdeckschicht 20 auf den Träger 15 kann der Träger 15 auch in einfacher Weise in ein laminiertes Zellkontaktiersystem integriert werden.

Die vorliegende Erfindung betrifft neben dem erfindungsgemäßen Verfahren gleichermaßen auch ein Verdrahtungs-Bauteil 10, welches nach dem erfindungsgemäßen Verfahren hergestellt worden ist.

Die Erfindung ermöglicht es, ein Verdrahtungs-Bauteil herzustellen, welches im Vergleich zu bisher bekannten entsprechenden Bauteilen erhebliche prozesstechnische Vereinfachungen bei gleichzeitig wirksamer Reduzierung der Einbauhöhe ermöglicht. Die Erfindung stellt daher einen ganz besonderen Beitrag auf dem einschlägigen Gebiet der Technik dar.

### BEZUGSZEICHENLISTE

- 10: Verdrahtungs-Bauteil
- 11: Leiterpfad
- 12: elektrischer Leiter
- 13: Führungskopf
- 14: Befestigungsmittel
- 15: Träger
- 16: Folie
- 17: Einbettungsschicht
- 18: Lasche
- 19: Einzel-Leiterpfad
- 20: Abdeckschicht
- 21: Anschluss

- 100: Energiespeichermodul
- 101: Energiespeicherzelle
- 102: Terminal (Energiespeicherzelle)
- 103: Zellverbinder
- 104: Montageeinheit Zellkontaktiersystem
- 105: Schweißposition

## Patentansprüche

1. Verfahren zum Herstellen eines Verdrahtungs-Bauteils (10) mit mindestens einem Leiterpfad (z. B. 11) insbesondere für oder als Bestandteil eines Zellkontaktiersystems (104), mit folgenden Schritten:
Bereitstellen eines ein- oder mehrschichtigen Trägers (15),
Bereitstellen eines elektrischen Leiters (12) für den Leiterpfad (11), Ausgeben des elektrischen Leiters (12) aus einem Führungskopf (13), wobei der Träger (15) und/oder der Führungskopf (13) in einer vorgebbaren Bahn zueinander zumindest in x- und y-Richtung, vorzugsweise in x-, y- und z-Richtung, translatorisch maschinell bewegt werden und der elektrische Leiter (12) zur Festlegung des Leiterpfades (11) entsprechend am Träger (15) fixiert wird,
**dadurch gekennzeichnet, dass**
der elektrische Leiter (12) am Träger (15) mittels bereichsweiser, thermoplastischer Aufweichung des Trägers (15) fixiert wird.

2. Verfahren nach Anspruch 1, **dadurch gekennzeichnet, dass** der Träger (15) eine Einbettungsschicht (17) zur Fixierung des elektrischen Leiters (11) umfasst.

3. Verfahren nach Anspruch 1 oder 2, **dadurch gekennzeichnet, dass** der Träger (15) ein flexibler Körper, insbesondere eine Folie (16), ist.

4. Verfahren nach Anspruch 1 oder 2, **dadurch gekennzeichnet, dass** der Träger (15) ein starrer Körper, insbesondere ein Formkörper, ist.

5. Verfahren nach den Ansprüchen 2 bis 4, **dadurch gekennzeichnet, dass** sich die Einbettungsschicht (17) auf dem flexiblen oder starren Körper befindet.

6. Verfahren nach den Ansprüchen 2 bis 5, **dadurch gekennzeichnet, dass** die Einbettungsschicht (17) eine Klebeschicht ist.

7. Verfahren nach den Ansprüchen 2 bis 6, **dadurch gekennzeichnet, dass** die Einbettungsschicht (17) durch einen von außen einwirkenden Energieeitrag in die Einbettungsschicht (17) aufgeweicht wird.

8. Verfahren nach Anspruch 7, **dadurch gekennzeichnet, dass** der von außen einwirkende Energieeintrag in die Einbettungsschicht (17) durch Einbringen von thermischer Erwärmung oder hochfrequenter Vibration erfolgt.

9. Verfahren nach Anspruch 8, **dadurch gekennzeichnet, dass** der von außen einwirkende Energieeitrag in die Einbettungsschicht (17) durch eine hochfrequente Vibration des Führungskopfs (13) während der Verlegung des elektrischen Leiters (12) erfolgt.

10. Verfahren nach Anspruch 9, **dadurch gekennzeichnet, dass** die Vibration des Führungskopfs (13) im Ultraschallbereich erfolgt.

11. Verfahren nach mindestens einem der vorherigen Ansprüche, **dadurch gekennzeichnet, dass** der elektrischen Leiter (12) durch mechanische Kraft in eine zumindest teilweise aufgeweichte oder viskose Einbettungsschicht (17) eingefügt wird.

12. Verfahren nach mindestens einem der vorherigen Ansprüche, **dadurch gekennzeichnet, dass** der am Träger (15) verlegte elektrische Leiter (12) Unterbrechungen aufweist und/oder sich überkreuzend angeordnet ist und/oder in x- und y-Richtung sowie auch in z-Richtung verläuft.

13. Verfahren nach mindestens einem der vorherigen Ansprüche, **dadurch gekennzeichnet, dass** der am Träger (15) verlegte elektrische Leiter (12) aus dem Träger (15) herausgeführt wird.

14. Verfahren nach mindestens einem der vorherigen Ansprüche, **dadurch gekennzeichnet, dass** der elektrische Leiter (12) mit Unterbrechungen verlegt wird.

15. Verfahren nach mindestens einem der vorherigen Ansprüche 1-13, **dadurch gekennzeichnet, dass** der elektrische Leiter (12) ohne Unterbrechungen verlegt wird und anschließend in mehrere Leiterpfade (11, 19) aufgetrennt wird.

16. Verfahren nach mindestens einem der vorherigen Ansprüche, **dadurch gekennzeichnet, dass** am Träger (15) mindestens ein funktionales Element, insbesondere mindestens ein Sensorelement, mindestens ein Steckelement und/oder mindestens eine PCB oder FPC angeordnet ist.

17. Verfahren nach mindestens einem der vorherigen Ansprüche, **dadurch gekennzeichnet, dass** der elektrische Leiter (12) isoliert oder nicht isoliert ist.

18. Verfahren nach mindestens einem der vorherigen Ansprüche, **dadurch gekennzeichnet, dass** auf die Oberseite des mindestens einen Leiterpfads (z. B. 11) mindestens eine Abdeckschicht (20), vorzugsweise eine Abdeckfolie, aufgebracht wird.

19. Verfahren nach mindestens einem der vorherigen Ansprüche, **dadurch gekennzeichnet, dass** der Träger (15) mit Zellverbindern (103) zu einem vorkonfektionierten Montageteil (104), vorzugsweise für den Einsatz als Zellkontaktiersystem, verbunden wird.

20. Verfahren nach mindestens einem der vorherigen Ansprüche, **dadurch gekennzeichnet, dass** der Träger (15) Laschen (15) umfasst, wobei sich der Leiterpfad (z. B. 11) vorzugsweise auch in den Bereich der Laschen (15) erstreckt, und/oder wobei die Laschen (15) vorzugsweise einen Höhenversatz des Trägers (15) bilden.

21. Verfahren nach mindestens einem der vorherigen Ansprüche, **dadurch gekennzeichnet, dass** der elektrische Leiter (12) über einen Teilbereich seines äußeren Umfangs von dem Träger (15) oder der Einbettungsschicht (17) kontaktiert ist, oder der elektrische Leiter (12) über seinen gesamten äußeren Umfang von dem Träger (15) oder der Einbettungsschicht (17) kontaktiert ist,

22. Verdrahtungs-Bauteil (10) mit mindestens einem Leiterpfad (z. B. 11) insbesondere für oder als Bestandteil eines Zellkontaktiersystems (104), **dadurch gekennzeichnet, dass** es gemäß dem Verfahren nach mindestens einem der vorherigen Ansprüche hergestellt ist.
